# EUROPEAN PATENT APPLICATION

(11) **EP 1 176 748 A2**
(43) Date of publication of application: **30.01.2002**
(21) Application number: 01117502.3
(22) Date of filing: 20.07.2001
(51) Int. Cl.: H04L 1/00, H04L 1/08

(54) **Method and apparatus for error correction**

(30) Priority: 26.07.2000 JP 2000225421
(71) Applicant: MITSUBISHI DENKI KABUSHIKI KAISHA, Tokyo 100-8310 (JP)
(72) Inventor: Yoshida, Hideo, Chiyoda-ku, Tokyo 100-8310 (JP); Nakamura, Takahiko, Chiyoda-ku, Tokyo 100-8310 (JP); Fujita, Hachiro, Chiyoda-ku, Tokyo 100-8310 (JP); Miyata, Yoshikuni, Chiyoda-ku, Tokyo 100-8310 (JP)
(74) Representative: Pfenning, Meinig & Partner GbR

(57) **Abstract**

In the conventional digital radio communications, 1/2 or more of a channel capacity has been used for error control. Thus, error resistance is high, and a digital compressed moving picture can be transmitted within a short time in the case of high-speed transmission. However, when large-capacity information, such as image data, is transmitted in low bit data transmission, e.g., a digital MCA system, transmission takes a long time even when an error is small on a transmission path. Conversely, a reduction in redundancy shortens transmission time, but reduces error resistance. Consequently, in the case of digital compressed image data, it was impossible to reproduce an image with respect to a 1-bit error. A method is disclosed for protecting data by correcting a plurality of errors. This method comprises the steps of: first transmitting data and the coded sequence of error correction codes having small redundancy; and then transmitting any one selected from the data, the coded sequence of the error correction codes, a check part of error correction codes for protecting data with respect to another correction sequence having a large correction capability for protecting the same data, the coded sequence the error correction codes, a check part of other error correction codes having a large correction capability with respect to the coded sequence of the error correction codes, and the coded sequence of the other error correction codes.

## Description

### BACKGROUND OF THE INVENTION

### 1. Field of the Invention

The present invention relates to an error correction system in a digital radio device, especially a system for efficiently transmitting data during low bit rate transmission. More particularly, the invention relates to a method and an apparatus for error correction with a concatenated code constitution.

### 2. Description of the Related Art

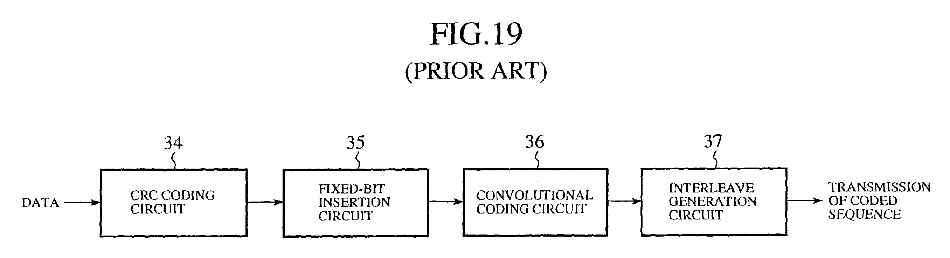

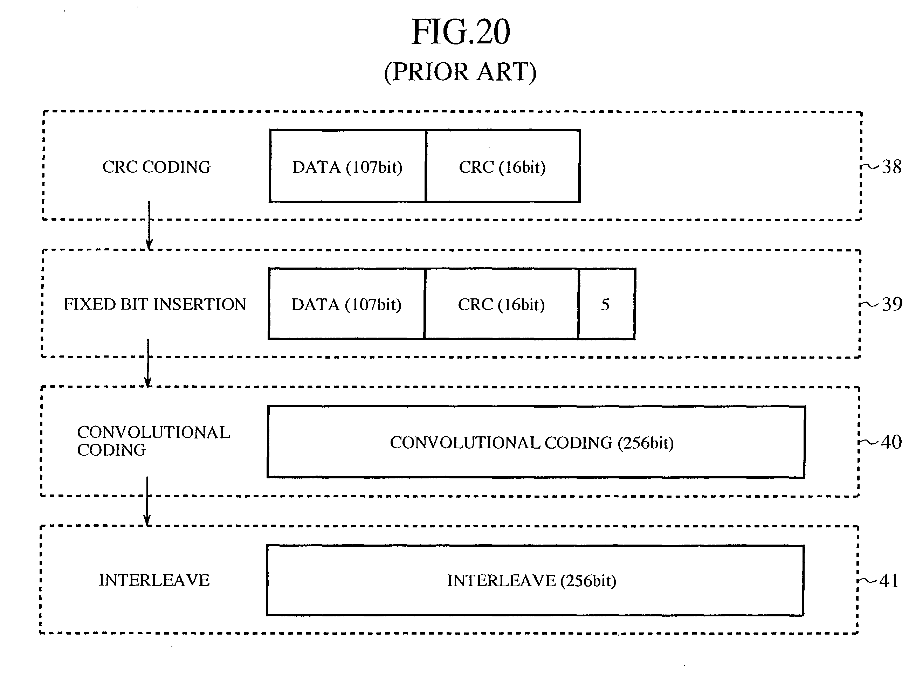

For example, Fig. 19 is a block diagram showing an apparatus used for the error correction method of channel coding in a public utility digital mobile communication system (RCR STD-39B). A reference numeral 34 denotes an error detection code (CRC) coding circuit for information; 35 a fixed-bit insertion circuit; 36 a convolutional coding circuit; and 37 an interleave generation circuit. Fig. 20 shows a change in the bit length at each of the circuits, wherein a reference numeral 38 denotes a change in the bit length at the output time of an error CRC coding; 39 at the output time of a fixed bit inserting circuit; 40 at the output time of a convolutional coding circuit; and 41 at the output time of interleave generation.

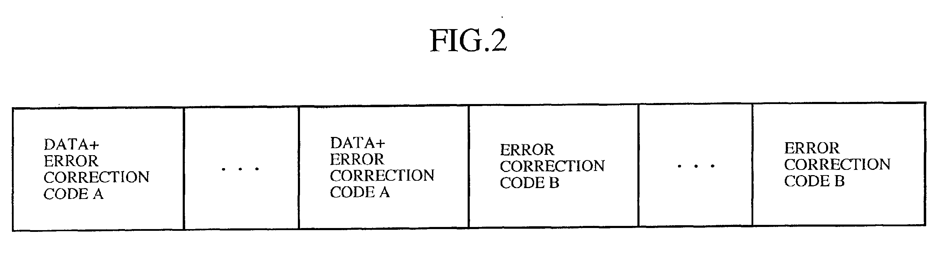

Next, an operation will be described. At the error detection code coding circuit 34, a 16-bit error detection code (CRC) is added to data (38 in Fig. 20). At the fixed bit insertion circuit 35, a 5-bit "0" fixed data as a tail bit of a convolutional code is added to the data generated by the error detection code coding circuit 34, and the CRC check bit. After the check bit, (39 in Fig. 29). At the convolutional coding circuit 36, convolutional coding of a rate 1/2 is carried out at a constraint length 6 (40 in Fig. 20). At the interleave generation circuit 37, a convolutional coded sequence is dispersed timewise (41 in Fig. 2) to increase resistance to a burst error.

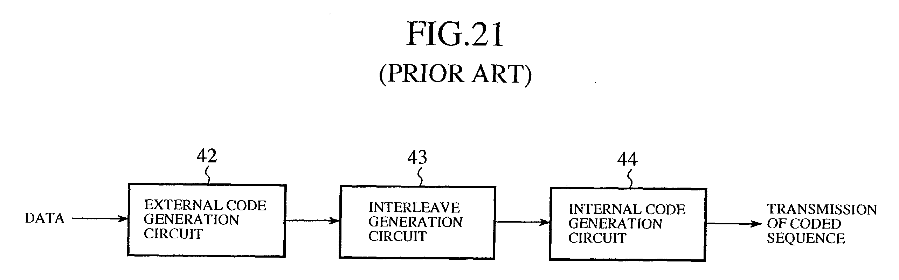

Fig. 21 is a block diagram showing an apparatus used for the concatenated code of a digital video broadcasting (DBV) error correction system. A reference numeral 42 denotes an external code generation circuit; 43 an interleave generation circuit; and 44 an internal code generation circuit.

Next, an operation will be described. At the external code generation circuit 42, data is subjected to coding by Read-Solomon (RS) code of a 204-byte code length and 188-byte data. The coded RS coded sequence enters the interleave generation circuit 43, and 12-stage convolutional interleaving is carried out. At the internal code generation circuit 44, the coded sequence having been subjected to interleaving is changed from a maximum rate of 1/2 to a rate of 7/8 depending on a channel state, based on the convolutional encoder of a rate of 1/2 with a constraint length 7.

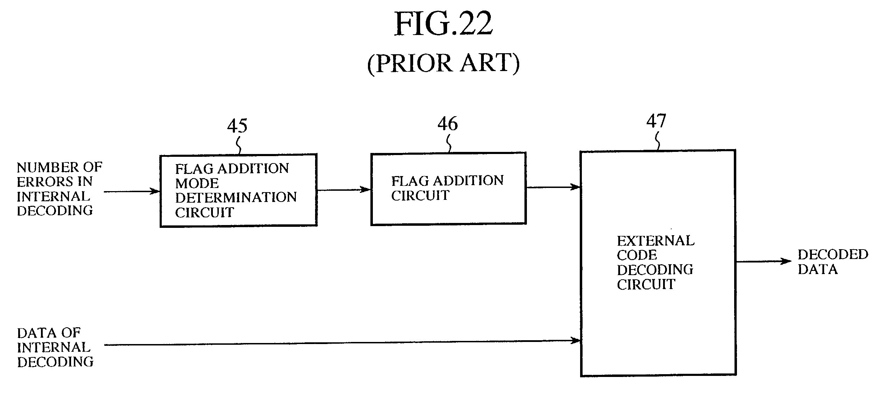

Fig. 22 is a schematic diagram showing a decoder for an error correction code, which is described in Japanese Patent Application Laid-Open No. 1995-202719. A reference numeral 45 denotes a flag addition mode determination circuit for determining at or over what number of errors a flag is to be added based on the number of errors obtained from an internal code; 46 a flag addition circuit for adding a flag upon receiving the determination result of the flag addition; and 47 an external code decoding circuit.

Next, an operation will be described. The flag addition mode determination circuit 45 calculates the number of code words having i number of errors, which is obtained by decoding an internal code composed of a plurality of code words, and then performs a plurality of flag control operations based on the detected i number errors. At the flag addition circuit 46, flag addition is carried out, which provides a plurality of bits of reliability information. The external code decoding circuit 47 selects, based on the plurality of flags, one of a plurality of decoding modes, and executes decoding.

As can be understood from the foregoing, in the conventional digital radio communications, to increase error resistance, 1/2 or more of a channel capacity is used for error control redundancy. Such error resistance is high, and a moving picture can be transmitted within a short time in the case of high-speed transmission, e.g., DVB. However, for example, if large-capacity information such as image data was transmitted in the case of low bit data transmission, e.g., a digital MCA system, transmission took a long time even when the number of error was small on a transmission path. Conversely, a reduction in redundancy shortens transmission time, but reduces error resistance. Thus, in the case of image data subjected to digital compression, it was impossible to reproduce an image with respect to a 1-bit error.

Furthermore, for decoding an external code of the concatenated code by using the number of corrected errors for an internal code, a complex operation, for example, reliability information addition mode control was necessary, in which a plurality of flags as reliability information were generated by counting code words of i-number errors, and thereby a decoding mode was switched.
The present invention was made to solve the foregoing problems, and objects of the invention are to provide a method and an apparatus for error correction, designed to build a digital radio communication system capable of transmitting data at a high speed when the number of error is small on a transmission path, and transmitting data with high reliability when the number of error is large on the transmission path.

Other objects of the invention are to provide a method and an apparatus for error correction, designed to perform decoding without any control of a reliability information addition mode, when the external code of a concatenated code is subjected to decoding by using the number of corrected errors for an internal code.

### SUMMARY OF THE INVENTION

A method and an apparatus for error correction of the present invention comprise transmission means and a method thereof, wherein the transmission means comprises: coding means for protecting data to be transmitted by a plurality of error correction codes; outputting means for first transmitting an error correction coded sequence including data, coded by an error correction code having small redundancy, including data, and subsequently transmitting an error correction coded sequence coded by an error correction code having a large correction capability; and storing section for storing the subsequently transmitted error correction coded sequence coded by an error correction code having a large correction capability.

A method and an apparatus for error correction of the present invention further comprise receiving means and a method thereof, wherein the receiving means comprises: a plurality of decoding means for decoding an error correction coded sequence including previously transmitted data and a subsequently transmitted error correction coded sequence including data coded by an error correction code having a large correction capability at a receiving side; determining means for decoding the error correction coded sequence including the previously transmitted data, and making determination as to the presence of an error in a result of the decoding; and outputting means for immediately outputting a result thereof if the presence of no errors is determined by the determining means.

A method and an apparatus for error correction of the present invention comprise transmission means and a method thereof, wherein the transmission means comprises coding means for protecting data to be transmitted by an error correction code having a large correction capability; coding means of an error correction code having small redundancy for protecting the data with respect to the check of the error correction code having the large correction capability; input switching means for entering the data and an error correction coded sequence coded by an error correction code having a large correction capability to the coding means of the error correction code having small redundancy; and storing section for storing an error correction coded sequence coded by an error correction code having a large correction capability for subsequent transmission.

A method and an apparatus for error correction of the present invention comprise receiving means and a method thereof, wherein it comprises: first means for decoding an error correction code having small redundancy at a receiving side; storing section for the decoded data by the decoding means regarding data; determining means for making determination as to the presence of an error in the decoding data of the decoding means; second decoding means for outputting data from the decoded data stored in the storing section and an error correction coded sequence coded by an error correction code having a large correction capability outputted from the first decoding means; and outputting means for immediately outputting a result thereof if the presence of no errors is determined by the determining means.

A method and an apparatus for error correction of the present invention comprise transmission means and a method thereof, wherein the transmission means comprises: coding means for protecting data to be transmitted by one error correction code; transmission procedure means for transmitting first only a part of a coded sequence including data, and subsequently transmitting a remaining error correction coded sequence; and storing section for storing an error correction coded sequence for subsequent transmission.

A method and an apparatus for error correction of the present invention comprise receiving means and a method thereof, wherein it comprises: decoding means for executing decoding by a part of an error correction coded sequence including previously transmitted data at a receiving side; storing section for storing the sequence to be received; decoding means for synthesizing a subsequently transmitted remaining error correction coded sequence with a part of an error correction coded sequence including the previously transmitted data, stored in the storing section, and then decoding the synthesized sequence; determining means for decoding the error correction coded sequence including the previously transmitted data, and making determination as to the presence of an error in the result of the decoding; and outputting means for immediately outputting the result thereof if the presence of no errors is determined.

A method and an apparatus for error correction of the present invention comprise transmission means and a method thereof, wherein the transmission means comprises, coding means for an internal code generated by a coded sequence composed of a plurality of code words regarding coding means for concatenated codes; and coding means for an external code for generating a convolutional code.

A method and an apparatus for error correction of the present invention comprise receiving means and a method thereof, wherein it comprises, regarding decoding means for concatenated codes at a receiving side; first decoding means of an internal code, for decoding a coded sequence composed of a plurality of code words, and outputting the number of errors; and a second decoding means of an external code, for executing decoding by using the decoded data of the internal code, and the number of errors, and based on the rule of a convolutional code.

### BRIEF DESCRIPTION OF THE DRAWINGS

Fig. 1 is a block diagram showing a transmission side apparatus according to a first embodiment of the present invention.
Fig. 2 is a constitutional view showing a transmission frame of the first embodiment.
Fig. 3 is a block diagram showing a receiving side apparatus of the first embodiment.
Fig. 4 is a block diagram showing a transmission side apparatus according to a second embodiment.
Fig. 5 is a block diagram showing a transmission side apparatus according to a fourth embodiment.
Fig. 6 is a constitutional view showing a transmission frame of the fourth embodiment.
Fig. 7 is a block diagram showing a receiving side apparatus of the fourth embodiment.
   Fig. 8 is a schematic view showing a transmission frame according to a fifth embodiment.
Fig. 9 is a block diagram showing a transmission side apparatus according to a sixth embodiment.
Fig. 10 is a constitutional view showing a transmission frame of the sixth embodiment.
Fig. 11 is a block diagram showing a receiving side apparatus of the sixth embodiment.
Fig. 12 is a block diagram showing another receiving side apparatus of the sixth embodiment.
Fig. 13 is a block diagram showing a transmission side apparatus according to a ninth embodiment.
Fig. 14 is a constitutional view showing a transmission frame of the ninth embodiment.
Fig. 15 is a block diagram showing a receiving side apparatus of the ninth embodiment.
Fig. 16 is a block diagram showing a receiving side apparatus according to a tenth embodiment.
Fig. 17 is a block diagram showing transmission and receiving side apparatus according to a twelfth embodiment.
Fig. 18 is a block diagram showing a transmission side apparatus according to a thirteenth embodiment.
Fig. 19 is a block diagram showing an apparatus used for a conventional error correction method.
Fig. 20 is a view of a transmission frame showing a change in the bit length at each of the circuits in Fig. 19.
Fig. 21 is a block diagram showing a transmission side apparatus of a DVB error correction system.
Fig. 22 is a schematic diagram showing another conventional decoder for an error correction code.

### DETAILED DESCRIPTION OF THE DRAWINGS

### (Embodiment 1)

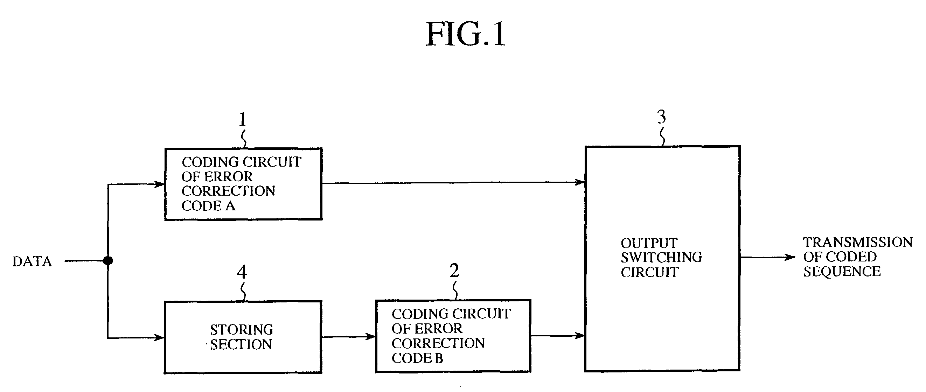

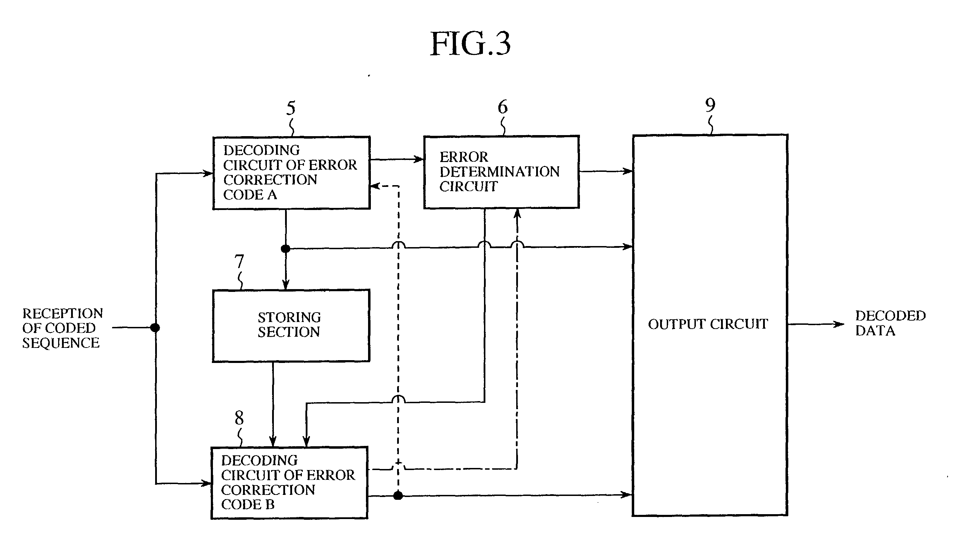

Fig. 1 is a block diagram showing a transmission side apparatus used for an error correction method according to the first embodiment of the present invention; and Fig. 3 a block diagram showing a receiving side apparatus. In Fig. 1, a reference numeral 1 denotes a coding circuit of an error correction code A; 2 a coding circuit of an error correction code B; 3 an output switching circuit for transmitting the error correction code A or B including data; and 4 a storing section for storing data.

In Fig. 3, a reference numeral 5 denotes a decoding circuit of the error correction code A; 6 an error determination circuit for determining whether or not an errors remains in the decoded result of the error correction code A; 7 a storing section for storing decoded data or the coded sequence of the error correction code A; 8 a decoding circuit of the error correction code B; and 9 an output circuit.

Next, an operation will be described. First, data is subjected to error correction coding by the coding circuit 1 of the error correction code A, and at the same time stored in the storing section 4. A coded sequence including the data having been subjected to the error correction coding by the coding circuit 1 is transmitted through the output switching circuit 3. This operation is continued until the transmission of all the data is completed.

After the transmission of all the data and the coded sequence of the error correction code A, the data stored in the storing section 4 is subjected to coding by the coding circuit 2 of the error correction code B, and transmitted through the output switching circuit 3. In this case, if the error correction code B is a systematic code, in which a check portion is added to the data, then only the check portion may be sent. Fig. 2 shows a transmission frame based on the described operation.

On the other hand, at the receiving side apparatus, the coded sequence to be received, of the error correction code A including the data transmitted first is subjected to decoding by the decoding circuit 5 of the error correction code A. The error determination circuit 6 determines whether or not an error remains in the correction result by the decoding circuit 5 of the error correction code A. The method of determination can easily detect errors, if for example an error detection code is contained in the data. In addition, for example, determination can be made based on the number of corrected errors by a block code, an error correction impossibility flag, or the like.

The data sequence decoded by the decoding circuit 5 of the error correction code Ais stored in the storing section 7.

If it is determined by the error determination circuit 6 that there are no errors in the data outputted from the decoding circuit 5 of the error correction code A, then the output circuit 9 outputs the result of the decoding by the decoding circuit 5 of the error correction code A as a decoded data sequence, and annuls the data sequence to be received, sent in following the coded sequence of the error correction code A including the data.

On the other hand, if it is determined by the error determination circuit 6 that there is an error in the data outputted from the decoding circuit 5 of the error correction code A, then decoding is carried out by the decoding circuit 8 of the error correction code B based on the decoded data sequence stored in the storing section 7 and the data sequence to be received of the subsequently received error correction code B. Then, from the output circuit 9, the result of the decoding by the decoding circuit 8 of the error correction code B is outputted as a decoded data sequence.

As in the conventional case, interleaving can be carried out for the error correction codes A and B. In addition, the data sequence may be divided into a plurality of blocks, and a block having the error correction codes A and B as a pair may be transmitted by a plurality of times.

At the receiving side, the decoded result by the decoding circuit 8 of the error correction code B may be entered to the determination circuit 6 in a manner like that indicated by a chain line arrow of Fig. 3. If the presence of an error is determined, then the decoding result by the decoding circuit 8 of the error correction code B may be entered to the decoding circuit 5 of the error correction code A in a manner like that indicated by a dotted line arrow, and subjected to correction again. At the error determination circuit 6, determination may be made again to see if there are any errors. If no errors are present, then the decoded result may be outputted from the output circuit 9. If the presence of an error is determined, then the decoded result may be stored again in the storing section 7, making it possible to execute repeated decoding, i.e., decoding again by the decoding circuit 8 of the error correction code, as in the foregoing case.

Furthermore, according to the embodiment, the two kinds of error correction codes, i.e., the error correction codes A and B, were prepared. However, three or more kinds of error correction codes can be used.

### (Embodiment 2)

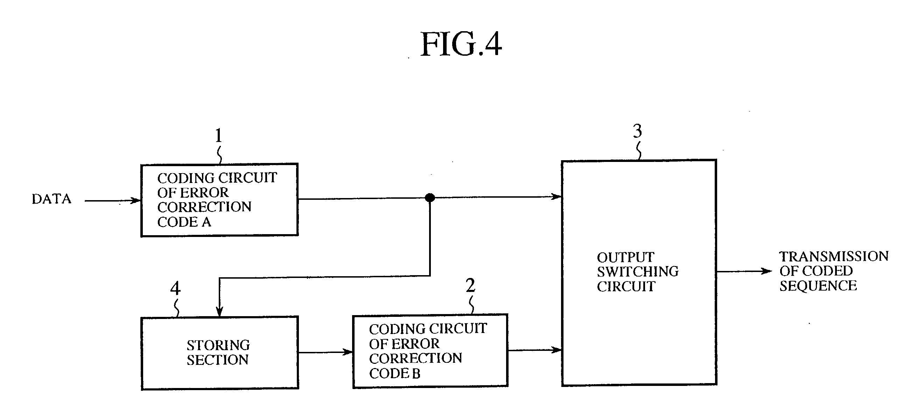

In the embodiment 1, at the transmission side, only the data to be sent was targeted for the coding of the error correction code B. However, the error correction code A including the data may be targeted for coding. Fig. 4 is a block diagram showing a transmission side apparatus of such a configuration. In Fig. 4, the storing section 4 is provided in a stage after that of the coding circuit 1, and adapted to store the coded sequence of the error correction code A. Other components are similar to those of the embodiment 1, denoted by similar reference numerals, and description thereof will be omitted.

Next, an operation will be described. First, data is subjected to error correction coding by the coding circuit 1 of the error correction code A. In this case, a sequence having been subjected to error correction coding by the coding circuit 1 of the error correction code A is stored in the storing section 4. In addition, the coded sequence including the data, having been subjected to error correction coding by the coding circuit 1 is transmitted through the output switching circuit 3. This operation is continued until the transmission of all the data is completed.

After the transmission of all the data and the coded sequence of the error correction code A, coding is carried out for the coded sequence stored in the storing section 4 by the coding circuit 2 of the error correction code B, and the result is outputted through the output switching circuit 3. In this case, if the error correction code B is a systematic code, in which a check portion is added to the date, then only a check portion may be transmitted.

On the other hand, the configuration of the receiving side is similar to that of Fig. 3. In the storing section 7, the coded sequence of the error correction code A including data decoded by the decoding circuit 5 of the error correction code A is stored. If the presence of no errors is determined by the determination circuit 6, as in the case of the embodiment 1, the data is outputted from the output circuit 9, the sequence of the subsequent error correction code B is abolished. If an error is detected, then the coded sequence of the error correction code A including the data is subjected to decoding by the decoding circuit 8 of the error correction code B.

In this case, if a data part can be separated from the coded sequence of the error correction code A including the data, the data can be outputted from the output circuit 9. However, it may be more advantageous to carry out repeated decoding. Specifically, the result of decoding by the decoding circuit 8 of the error correction code B is entered to the determination circuit 6 in a manner like that indicated by the chain line arrow of Fig. 3, determination is made as to whether or not an error remains. If there is an error, the decoded result is entered again to the decoding circuit 5 of the error correction code A in a manner like that indicated by the dotted line arrow of Fig. 3, and then subjected to decoding.

As in the case of the embodiment 1, interleaving can be carried out in the embodiment 2, and three or more kinds of error correction codes can be used. Moreover, the data sequence may be divided into a plurality of blocks, and a block having the error correction codes A and B as a pair may be transmitted by a plurality of times.

### (Embodiment 3)

In the embodiment 1 or 2, by transmitting the error correction code A as a block code such as BCH code or the like, and the error correction code B as a convolutional code of a systematic type, at the transmission side, regarding a convolutional code having a high correction capability, only a check part of the convolutional code can be easily transmitted later on.

At the receiving side with respect to the transmission side, for example, in Fig. 3, the number of corrected errors is monitored in the decoding circuit 5 of the error correction code A as a block code, and the number of corrected errors is stored with the data in the storing section 7. If it is determined by the determination circuit 6 that an error remains, then the number of corrected errors is entered with the data stored in the storing section 7 at the decoding circuit 8 of the error correction code B, and a check sequence of the error correction code B is entered from the sequence to be received.

In this case, to reflect the state of error correction in the decoding of the error correction code A, for example, reliability is set to a highest soft determination value for a bit determined to have no errors by the error correction code A. For the bit sequence of the error-corrected error correction code A, a soft determination value corresponding to the number of corrected errors is given. For a part determined to be impossible to correct by the error correction code A, a soft determination value equal to that of a check sequence is given, and by Viterbi decoding, for example, soft determination decoding is facilitated, improving the decoding capability.

According to the embodiment, at the receiving side, the soft determination decoding by the decoding circuit 8 of the error correction code B was carried out only when an error was detected by the determination circuit 6 after the decoding of the coded sequence of the error correction code A as all the block codes containing the data at the decoding circuit 5 of the error correction code A. However, without providing the determination circuit 6, the data stored in the storing section 7 is entered to the decoding circuit 8 of the error correction code B unconditionally. Th data may be divided into a plurality, and a block having pluralities of error correction codes A and B are a pair may be transmitted by a plurality of times.

### (Embodiment 4)

In the embodiments 1 to 3, the transmission form was made on the fixed data length. However, even if a data length is varied, it is possible to perform an operation similar to that of each of the foregoing embodiments by inserting the data length into data.

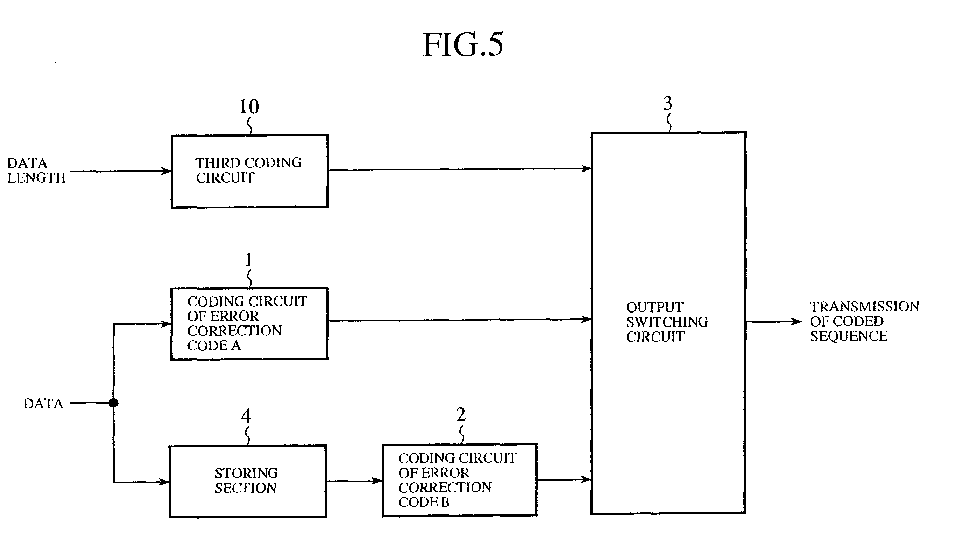

Fig. 5 is a block diagram showing a transmission side apparatus according to the fourth embodiment applied to the case of a variable data length, in which a data length is inserted into a data. In Fig. 5, a reference numeral 10 denotes a third error correction coding circuit for performing an error correction coding regarding the data length, and its output is entered to the output switching circuit 3. Otherwise, other components are similar to those in Fig. 1.

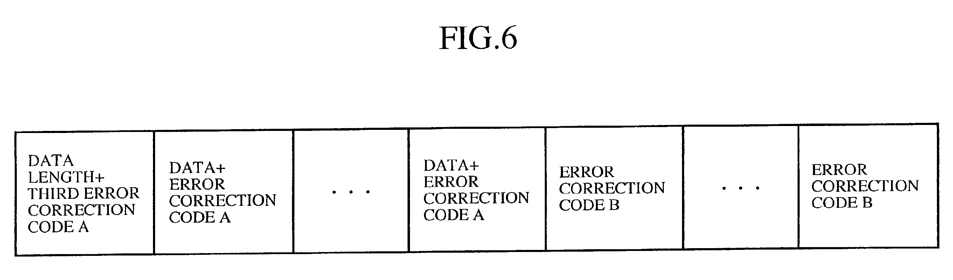

Next, an operation will be described. First, the data length is entered to the third coding circuit 10, and error correction coding is carried out. Then, the data is outputted before the coded sequence of the error correction code A including data from the output switching circuit 3. In this case, it is assumed that a maximum vale of the data length is predetermined, and a third error correction code length using the data length as information is constant. Coding by the third error correction coding circuit 10 should preferably be stronger than the error correction code A. Thereafter, an operation similar to that of the embodiment 1 or 3 is carried out. Fig. 6 shows a transmission frame based on the described operation.

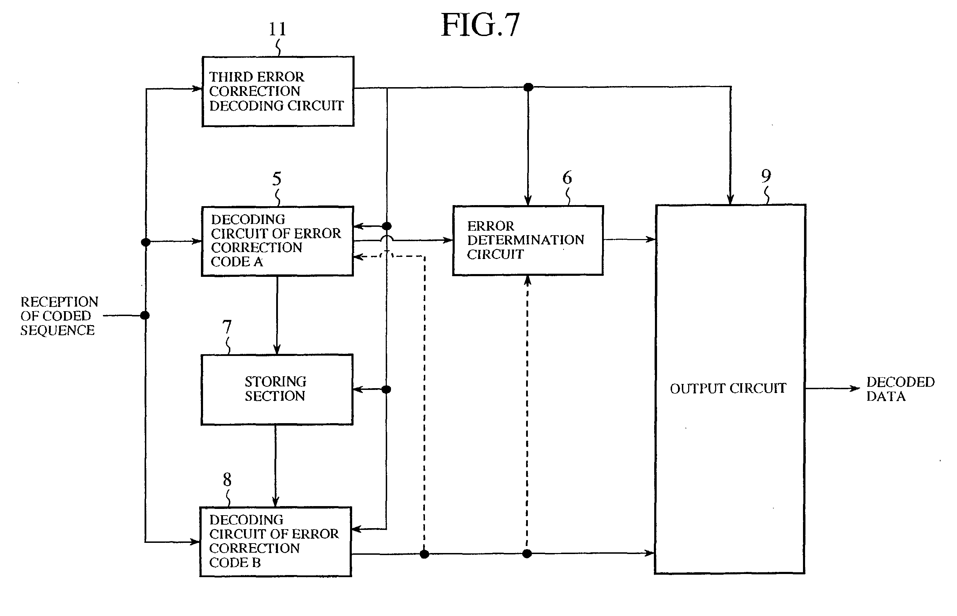

On the other hand, the configuration of the receiving side with respect to the transmission system is, for example, similar to that shown in Fig. 7. In Fig. 7, a reference numeral 11 denotes a third error correction decoding circuit, and its output is entered to each of the decoding circuit 5 of the error correction code A, the error correction determination circuit 6, the storing section 7, the decoding circuit 8, and the output circuit 9. Other components are similar to those shown in Fig. 3.

Next, an operation will be described. At the receiving side apparatus of such a configuration, it is assumed that the data length has been inserted into the data. Accordingly, first, a fixed bit length from the head of the received data is recognized as a third correction coded sequence including the data length, entered to the third error correction decoding circuit 11, and error correction is executed. The data length thus obtained is entered to each of the decoding circuit 5 of the error correction code A, the determination circuit 6, the storing section 7, the decoding circuit 8 of the error correction code B, and the output circuit 9 and, based on the data length, an operation similar to that of the embodiment 1 or 3 is carried out.

In the described embodiment, the third error correction coded sequence including the data length was directly outputted. However, the third error correction coded sequence including the data length may be entered to the coding circuit 1 of the error correction code A, and subjected to coding while it is contained in the error correction code A. In this case, at the receiving side, the coded sequence is decoded by the error correction code A at the decoding circuit 5 of the error correction code A, and then entered to the decoding circuit 11 of the third error correction code to obtain the data length.

### (Embodiment 5)

In the foregoing embodiment 4, one obtained by coding the data with the third error correction code was transmitted once. In this case, the data length may not be obtained at the receiving side if an error rate is greatly reduced during the transmission of the data length. This problem can be solved by transmitting the third error correction code including the data length by a plurality of times in the coded sequence of the error correction code A.

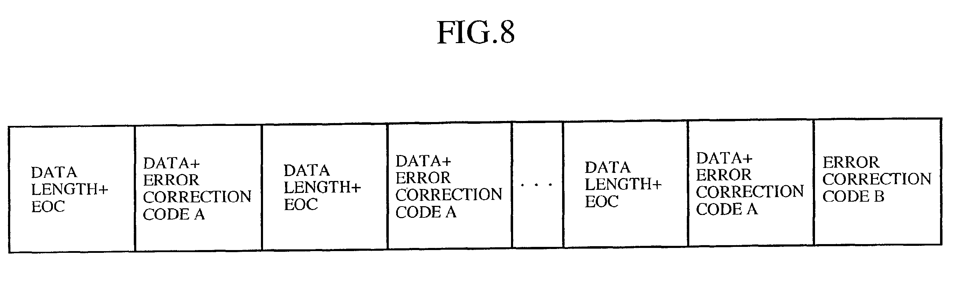

Fig. 8 is a constitutional view of a transmission frame according the embodiment 5. As apparent from the drawing, for the third error correction coded sequence including the data length, the coded sequence of the error correction code Aincluding all the data is divided into a plurality of blocks, and transmitted in the transmission order of inserting the third coded sequence including the data length for each block.

To realize the embodiment by the configuration of Fig. 5, the third coded sequence including the data length is stored in the coding circuit 10 of the third error correction code. At the output circuit 3, a block length outputted from the coding circuit 1 of the error correction code A is controlled, and the third coded sequence including the data length is inserted therein, and outputted.

On the other hand, at the receiving side, if the third coded sequence including the data length has been entered in Fig. 7, decoding is carried out by the decoding circuit 11 of the third error correction code. If correct data is determined to have been obtained, then the data is held as a data length. As a method for determining a correct data length, one may be selected from a method for making determination based on coincidence among a plurality of bits of data length information obtained, and a method for transmitting one obtained by adding an error detection code to a data length and coding it by the third error correction code, correcting an error by the decoding circuit 11 of the third error correction code, and then detecting an error by using the error detection code. Needless to say, the third error correction code can be provided with an error detection function.

### (Embodiment 6)

In the foregoing embodiments 1 to 5, the data or the error correction code A including the data was subjected to coding by the error correction code B. However, a similar advantage can be obtained by coding the data and the error correction code B by the error correction code A, and transmitting it.

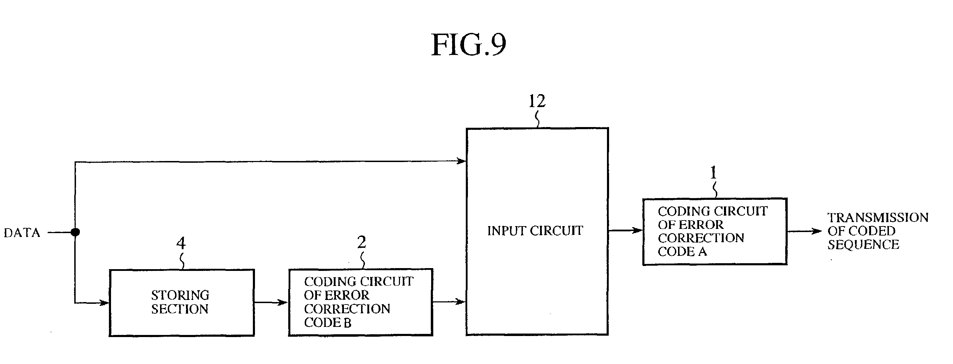

Fig. 9 is a block diagram showing a transmission side apparatus according to the sixth embodiment. In Fig. 9, a reference numeral 1 denotes the coding circuit of an error correction code A; 2 the coding circuit of an error correction code B; 4 a storing section for storing data; and 12 an input circuit for switching an input to the coding circuit 1 of the error correction code A.

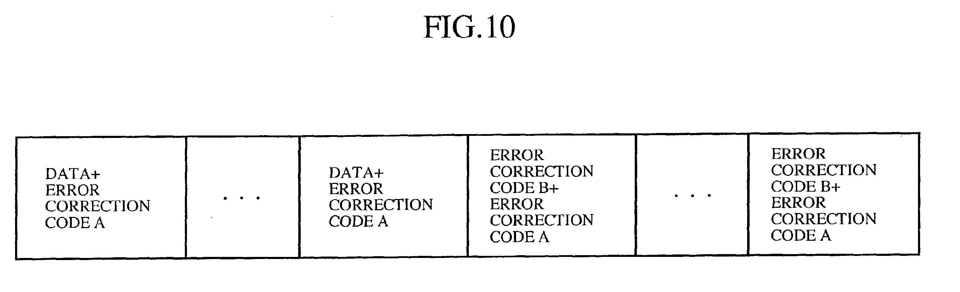

Next, an operation will be described. First, data is entered to the coding circuit 1 of the error correction code A by the input circuit 12, and subjected to error correction coding. On the other hand, the data is stored in the storing section 4. A coded sequence including the data coded by the coding circuit 1 of the error correction code A is transmitted before all the data. Then, coding is executed to the data from those stored in the storing section 4 by the coding circuit 2 of the error correction code B. The coded sequence is entered through the input circuit 12 to the coding circuit 1 of the error correction code A, coded by the error correction code A, and then transmitted. Fig. 10 shows a transmission frame based on the described operation.

If the error correction code B is a systematic code, in which the code is separated into data and a check portion, then it may be only a check portion of the error correction code B that is entered to the input circuit 12 by the coding circuit 2 of the error correction code B.

In addition, a relation between the coding circuit 2 of the error correction code B and the storing section 4 may be opposite.

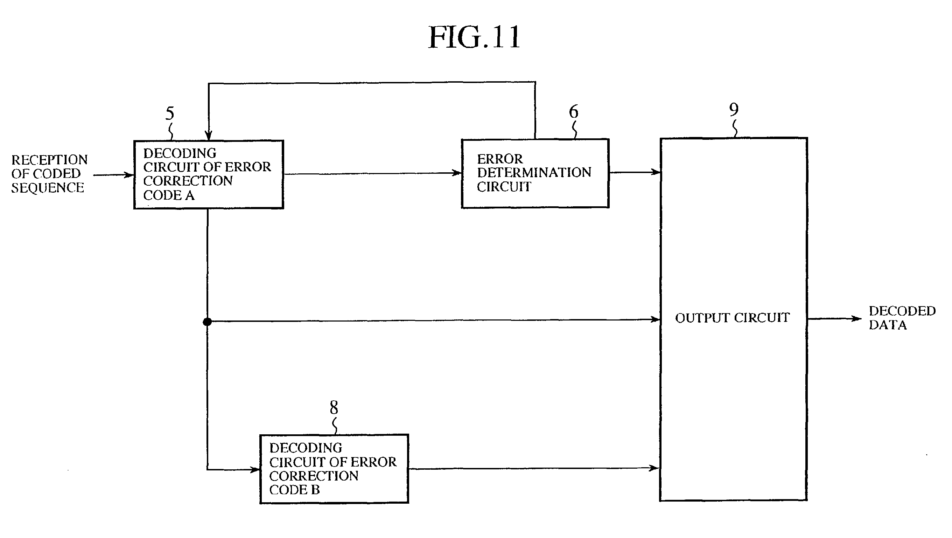

Next, the receiving side will be described. Fig. 11 is a block diagram showing a receiving side apparatus according to the embodiment 6. In Fig. 11, a reference numeral 5 denotes the decoding circuit of the error correction code A; 6 a determination circuit for determining whether or not an error remains in the decoding result of the error correction code A; 8 the decoding circuit of the error correction code B; and 9 an output circuit.

Now, the operation of the receiving side apparatus thus constructed will be described. First, the coded sequence to be received, of the error correction code A including first transmitted data is entered to the decoding circuit 5 of the error correction code A, and subjected to decoding. The error determination circuit 6 determines whether an error is remaining or not in the correction result by the decoding circuit 5 of the error correction code A. The determination method can easily detect an error, for example if an error detection code is contained in the data. Also, for example, determination can be made based on the number of corrected errors in the block code, an error correction impossibility flag or the like.

If it is determined by the error determination circuit 6 that there are no errors in the data outputted from the decoding circuit 5 of the error correction code A, then the result of decoding by the decoding circuit 5 of the error correction code A is outputted as a decoded data sequence by the output circuit 9, and the sequence to be received, transmitted after the coded sequence of the error correction code A including the data is not received.

On the other hand, if it is determined by the error determination circuit 6 that there is an error in the data outputted from the decoding circuit 5 of the error correction code, then the coded sequence of the error correction code A using the coded sequence of the subsequent error correction code B as information is entered to the decoding circuit 5 of the error correction code A, and subjected to decoding. The decoded sequence decoded by the error correction code A is decoded by the decoding circuit 8 of the error correction code B, and the result of the decoding by the decoding circuit 8 of the error correction code B is outputted as a decoded data sequence by the output circuit 9.

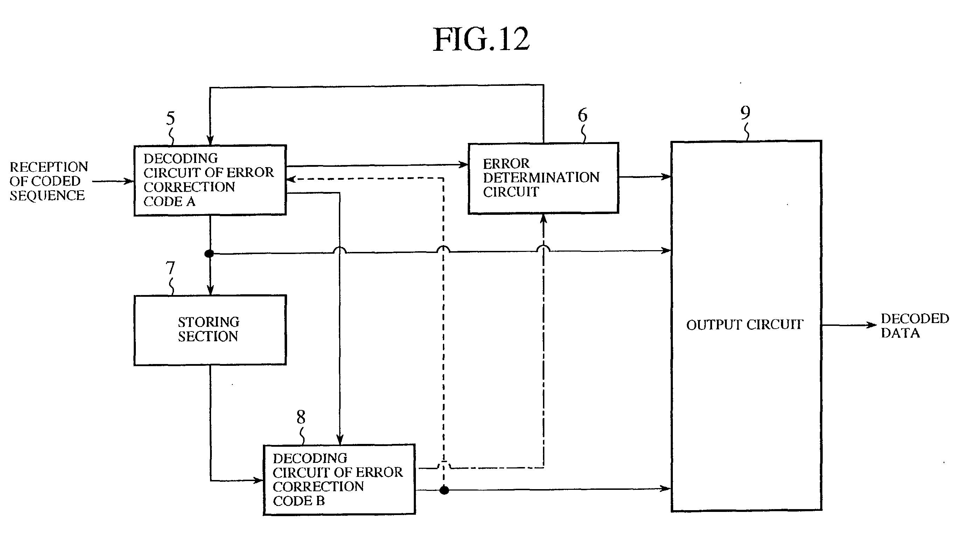

Fig. 12 is a configuration diagram of a receiving side apparatus when the error correction code B is a systematic code, and the check of the error correction code B is subjected to correction coding, and transmitted from the transmission side after the data. In Fig. 12, a reference numeral 7 denotes storing section adapted to a decoded sequence decoded by the decoding circuit 5 of the error correction code A. The stored content thereof is outputted to the decoding circuit 8 of the error correction code B. Other components are similar to those of the configuration shown in Fig. 11.

Next, an operation will be described. First, the coded sequence to be received, of the error correction code A including first transmitted data is entered to the decoding circuit 5 of the error correction code A, and subjected to decoding. The result of the decoding is stored in the storing section 7. The error determination circuit 6 determines whether an error is remaining in the correction result by the decoding circuit 5 of the error correction code A. The determination method can easily detect an error, for example if an error detection code is contained in the data. Also, for example, determination can be made based on the number of corrected errors in the block code, an error correction impossibility flag or the like.

If it is determined by the error determination circuit 6 that there are no errors in the data outputted from the decoding circuit 5 of the error correction code A, then the result of the decoding by the decoding circuit 5 of the error correction code A is outputted as a decoded data sequence from the output circuit 9, and the sequence to be received, transmitted after the coded sequence of the error correction code A including the data, is annulled.

On the other hand, if it is determined by the error determination circuit 6 that there is an error in the data outputted from the decoding circuit 5 of the error correction code A, then the coded sequence of the error correction code A using the check sequence of the subsequent error correction code B as information is entered to the decoding circuit 5 of the error correction code A, and subjected to decoding. The check sequence of the error correction code B having been decoded by the error correction code A is entered, together with the data stored in the storing section 7, to the decoding circuit 8 of the error correction code B, and subjected to decoding. The result of the decoding by the decoding circuit 8 of the error correction code B is outputted as a decoded data sequence from the output circuit 9.

As in the conventional case, interleaving can be carried out for the error correction codes A and B. Moreover, the data sequence may be divided into a plurality of blocks, and a block having the error correction codes A and B as a pair may be transmitted by a plurality of times.

Note that if the error correction code B is a systematic code, at the receiving side, the decoded result by the decoding circuit 8 of the error correction code B is entered to the determination circuit in a manner like that indicated by a chain line arrow of Fig. 12. If the presence of an error is determined, then the decoded result by the decoding circuit 8 of the error correction code B is entered to the decoding circuit 5 of the error correction code Ain a manner like that indicated by a dotted line arrow, and subjected to correction again. Error determination is made again by the error determination circuit 6 and, if there are no errors, then the correction result is outputted from the output circuit 9. If there is an error, as in the foregoing case, repeated decoding can be carried out, i.e., decoding is executed again by the decoding circuit 8 of the error correction code B.

Furthermore, in the described embodiment, the two kinds of error correction codes, i.e., the error correction codes A and B, are used. However, by addition as in the case of the error correction code B added to the code A, three or more kinds of error correction codes can be used.

### (Embodiment 7)

In the embodiment 6, by transmitting the error correction code A as a block code such as a BCD code, and the error correction code B as the convolutional code of a systematic type, at the transmission side, for the convolutional code having a high correction capability, only a check part of the convolutional code can be easily transmitted later on, obtaining an advantage similar to that of the embodiment 3.

Especially, if the decoding circuit 8 of the error correction code B as a systematic convolutional code performs soft determination decoding in the configuration of the embodiment, then a soft determination value can also be given to the check part by the decoding circuit 5 of the error correction code A as a block code. Accordingly, it is possible to improve the correction capability of the decoding circuit 8 of the error correction code B as a systematic convolutional code. In addition, the improvement of the correction capability can be expected by executing repeated decoding.

### (Embodiment 8)

In the embodiment 6, the transmission form was based on the assumption that the data length was constant. However, even if a data length is varied, as in the case of the embodiment 4 or 5, an operation similar to that of the embodiment 6 can be carried out by inserting the data length in the data

### (Embodiment 9)

In the embodiments 1 to 8, the transmission system of the error correction method and apparatus was provided, for efficiently transmitting the data by using two or more kinds of error correction codes. However, a similar advantage can be obtained even if only one kind of error correction code is used.

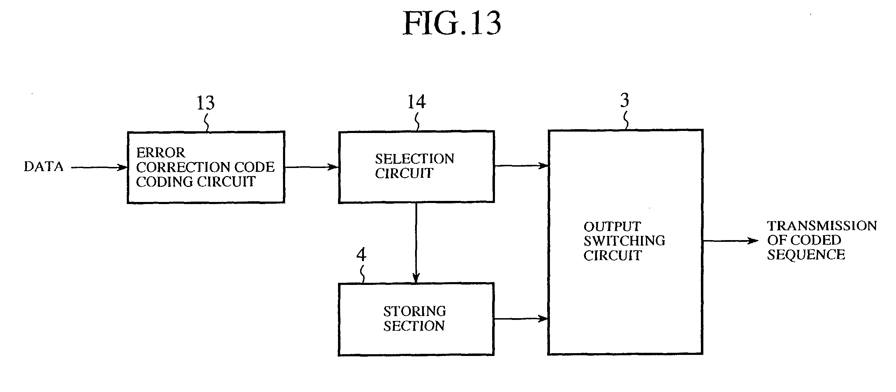

Fig. 13 is a block diagram showing a transmission side apparatus used for an error correction method according to the ninth embodiment of the invention. In Fig. 13, a reference numeral 13 denotes an error correction coding circuit; 3 an output circuit for outputting a correction coded sequence including data; 4 a storing section for storing a part or all parts of the error correction coded sequence; and 14 a selection circuit for selecting the output of a coded sequence to the output circuit and the storing section 4.

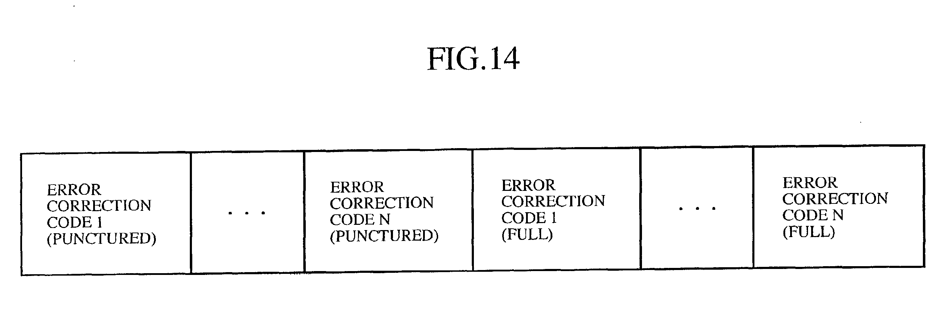

Next, an operation will be described. First, the data is subjected to error correction coding by the coding circuit 13 of the error correction code, and entered to the selection circuit 14. At the selection circuit 14, based on the particular rule of a predetermined cycle, all or a part of the coded sequence is transmitted through the output circuit 3. At the selection circuit 14, simultaneously, all of the coded sequence of the data having been subjected to error correction coding by the coding circuit 13, or a part of the coded sequence based on the particular rule of a predetermined cycle, is stored in the storing section 4. After the transmission of the coded sequence through the selection circuit 14 and the output circuit 3 regarding all the data, the data stored in the storing section 4 is transmitted through the output circuit 3. Fig. 14 shows a transmission frame based on the described operation. In this case, all parts of the coded sequence are stored in the storing section 4.

One specific example of a convolutional code of a rate 1/2 as an error correction code will be described. At the coding circuit 13 of the error correction code, a convolutiuonal code of a rate 1/2 is set and, at the selection circuit 14, for example one having a rate 7/8 is selected from the coded sequence coming-in at a rate of 1/2 based on a punctured rule, and outputted from the output circuit 3.

On the other hand, the punctured bit sequence of a rate 6/14 is stored in the storing section 4, and after all the data are transmitted as convolutional codes of a coding rate 7/8, the output circuit 3 is switched to the storing section 4, and the transmission is continued.

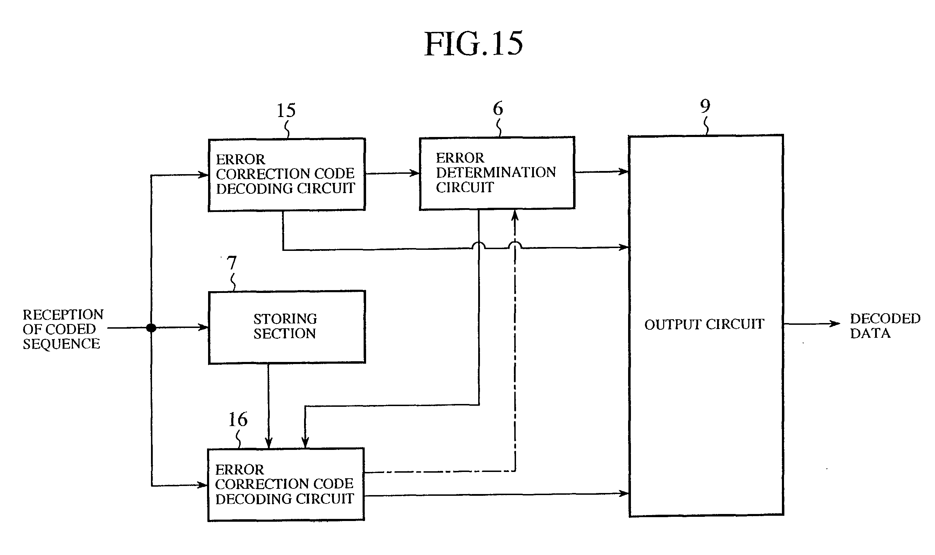

Next, the receiving side will be described. Fig. 15 is a block diagram showing a receiving side apparatus according to the embodiment 9. In Fig 15, a reference numeral 15 denotes the decoding circuit of an error correction code; 6 an error determination circuit for determining whether or not an error remains in a decoding result by the decoding circuit 15 of the error correction code; 7 a storing section for storing a sequence to be received, identical to one entered to the decoding circuit 15 of the error correction code; 16 another decoding circuit of an error correction code; and 9 an output circuit.

Now, the operation of the receiving side apparatus thus constructed will be described. First, the sequence to be received, as the coded sequence of an error correction code having a high rate, is subjected to decoding by the decoding circuit 15 of the error correction code. Simultaneously, the sequence to be received is stored in the storing section 7. The error determination circuit 6 determines whether or not an error remains in the correction result by the decoding circuit 15 of the error correction code. The method of determination can easily detect an error, for example if an error correction code is contained in the data. Also, for example, if the error correction code is a block code, then determination can be made based on the number of corrected errors, an error correction impossibility flag or the like.

If it is determined by the error determination circuit 6 that there are no errors in the data outputted from the decoding circuit 15 of the error correction code, the result of rate decoding by the decoding circuit 15 is outputted as a decoded data sequence from the output circuit 9, and the subsequent sequence to be received is annulled.

On the other hand, if it is determined by the error determination circuit 6 that there is an error in the data outputted from the decoding circuit 15 of the error correction code, then at the decoding circuit 16, a subsequently received error correction coded sequence is inserted into the sequence to be received, stored in the storing section 7, and subjected to decoding. From the output circuit 9, the result of the decoding by the decoding circuit 16 of the error correction code is outputted as a decoded data sequence.

As indicated by a chain line arrow of Fig. 15, determination may be made by the determination circuit 6 as to the presence of a remaining error in the data based on the decoded result by the decoding circuit 16 of the error correction code.

Now, one specific example of transmitting a convolutional code of a rate 1/2 as an error correction code as in the case of the transmission side will be described. First, a convolutional code of a rate 7/8 is transmitted, and subsequently the remaining coded sequence of a rate 6/14 is transmitted. In this case, the convolutional code of a rate 7/8 is subjected to decoding by the decoding circuit 15 of the error correction code 15, and the sequence to be received, of the convolutional code of a rate 7/8 is stored in the storing section 7. At the decoding circuit 16 of the error correction code, a subsequently received coded sequence of a rate 6/14 is inserted into the convolutional code of a rate 7/8 stored in the storing section 7, and the convolutional code of a rate 1/2 is subjected to decoding.

For the transmission of the error correction code, interleaving can be carried out as in the conventional case. In addition, the coded sequence to be transmitted first, and the coded sequence to be subsequently transmitted may be one and the same.

Furthermore, at the receiving side, if soft determination information is obtained corresponding to the sequence to be received, soft determination decoding can be carried out at the decoding circuit 15 and 16 of the error correction codes, making it possible to improve a correction capability.

### (Embodiment 10)

At the receiving side of the embodiment 9, the decoding circuits 15 and 16 of the error correction codes were provided. However, since the error correction code is one and the same, one of the decoding circuit can be used for the other.

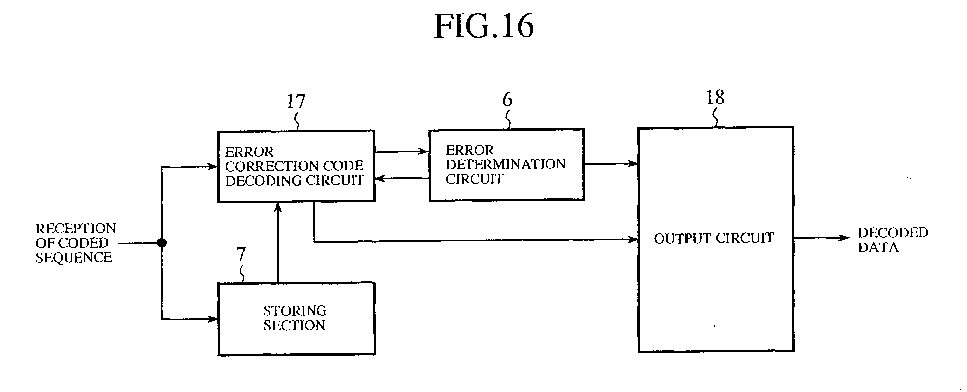

Fig. 16 is a block diagram showing such an embodiment. In Fig. 16, a reference numeral 17 denotes the decoding circuit of an error correction code, serving also as another; 6 an error determination circuit for determining whether or not an error remains in the result of decoding performed by the decoding circuit 17 of the error correction code; 7 a storing section for storing a sequence to be received, entered to the decoding circuit 17 of the error correction code; and 18 an output circuit.

Next, an operation will be described. First, a sequence to be received, as the first-transmitted coded sequence of an error correction code having a high rate, is subjected to decoding by the decoding circuit 17 of the error correction code according to a rate. Simultaneously, the sequence to be received is stored in the storing section 7. The error determination circuit 6 determines whether or not an error remains in the correction result by the decoding circuit 17 of the error correction code. The method of determination can easily detect an error, for example if an error correction code is contained in the data. Also, for example, if the error correction code is a block code, determination can be made based on the number of corrected errors, an error correction impossibility flag or the like.

If it is determined by the error determination circuit 6 that there are no errors in the data outputted from the decoding circuit 17 of the error correction code, the result of decoding performed by the decoding circuit 17 of the error correction code is outputted as a decoded data sequence from the output circuit 18, and a subsequent sequence to be received is annulled.

On the other hand, if it is determined that there is an error in the data outputted from the decoding circuit 17 of the error correction code, the sequence to be received, stored in the storing section 7, is returned to the decoding circuit 17 of the error correction code, and the subsequently received error correction coded sequence is inserted therein. Then, the returned sequence is subjected to decoding by the decoding circuit 17 of the error correction code according to the rate, and the result of the decoding is outputted as a decoded data sequence from the output circuit 8. Also, in this case, determination may be made by the error determination circuit 6 as to the presence of a remaining error in the data.

### (Embodiment 11)

In the foregoing embodiments 9 and 10, it was assumed that the data length was known at each of the transmission and receiving sides. However, even if a data length is variable, by transmitting the data length in the same manner as that of the embodiment 4 or 5, a variable length can be dealt with. If the data length, and an error correction code for protecting the data length or the coded sequence of en error detection code are transmitted during the transmission of the coded sequence to be transmitted first as in the case of the embodiment 5, the coded sequence to be transmitted first is divided at predetermined bit lengths into blocks, and a coded sequence regarding the data length may be transmitted for each block.

### (Embodiment 12)

In the foregoing embodiments 1 to 11, the apparatus having a configuration dedicated to the error correction method. However, similar processing can be easily realized by using an apparatus having a general-purpose computer, e.g., a personal computer (PC). and a general-purpose memory.

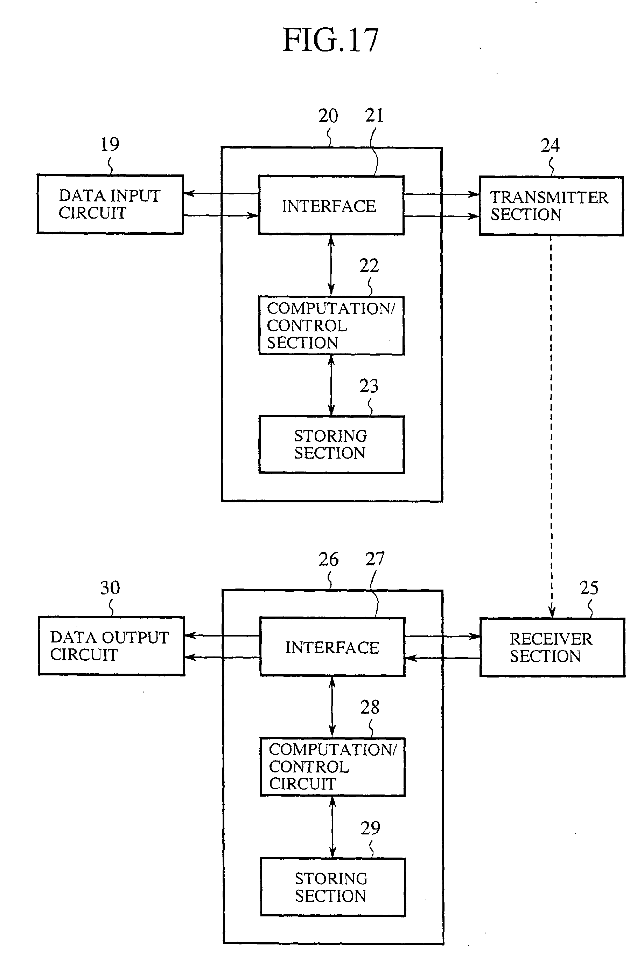

Fig. 17 is a block diagram showing such an embodiment. A reference numeral 19 denotes data input circuit such as a digital camera or the like; 20 a transmission side general-purpose computing section; 21 an interface for transferring data between the inside and the outside of the transmission side general-purpose computing section 20; 22 computation/control section such as a general-purpose processor or the like in the transmission side general-purpose computing section 20; 23 a storing section such as the one represented by a semiconductor memory in the transmission side general-purpose computing section 20; and 24 a transmitter section such as a portable telephone set or the like. These components constitute a transmission side apparatus.

Likewise, a reference numeral 25 denotes receiver section such as a portable telephone set; 26 a receiving side general-purpose computing section; 27 an interface in the receiving side general-purpose computing section 26; 28 a computation/control section in the receiving side general-purpose computing section 26; 29 a storing section in the receiving side general-purpose computing section 26; and 30 a data output circuit such as a display or the like. These components constitute a receiving side apparatus.

Next, an operation will be described. Here, processing similar to that of the embodiment 1 is executed by the general-purpose computing section 20. At the transmission side, first, data obtained by the data input circuit 19 is stored in the storing section 23 through the interface 21, and the computation/control section 22 of the general-purpose computing section 20. Then, processing similar to that of the coding circuit 1 and 2 of the error correction codes A and B shown in Fig. 1 is executed by using the computation/control section 22 and the storing section 23.

After the completion of the processing regarding the error correction coding, a coded sequence is outputted to the transmitter section 24 through the interface 21 of the general-purpose computing section 20. In this case, control is performed by the computation/control section 22 such that the coded sequence of the error correction code A including the data, stored in the storing section 23, is outputted first, and the coded sequence of the error correction code B is subsequently transmitted. At the general-purpose computing section 20, error correction coding processing and output processing to the transmitter section 24 may be executed in a time division manner or simultaneously.

The transmitter section 24 makes connection to an opposite party for transmission, namely the receiver section, and transmits the coded sequence outputted from the general-purpose computing section 20.

On the other hand, at the receiving side, to receive the data from the transmitter section 24, the general-purpose computing section 26 of the receiving side is prepared, and a sequence to be received is received from the receiver section 25 through the interface 27 of the general-purpose computing section 26. The received sequence to be received is temporarily stored in the storing section 29 by the computation/control section 28.
When the coded sequence of the error correction code A including the data is set, the error correction code A is immediately subjected to decoding by the computation/control section 28, and the result thereof is stored in the storing section 29.

After the completion of the decoding of the error correction code A for all the data, the computation/control section 28 determines whether or not there is an error in the decoded result stored in the storing section 29. The determination method can easily detect an error, for example if an error detection code is contained in the data. Also, for example, determination can be made based on the number of corrected errors in the block code, an error correction impossibility flag or the like.

If the presence of no errors is determined in the above determination processing, then the computation/control section 28 stops the receiving processing of the receiver section 25 through the interface 27, and the decoded data stored in the storing section 29 is outputted through the interface 27 to the data output circuit 30.

On the other hand, if the presence of an error is determined in the determination processing, then the receiving operation is continued. When the coded sequence of the error correction code B is set, the error correction code B is subjected to decoding by the computation/control section 28 also using the decoded data decoded by the error correction code A, and the result thereof is stored in the storing section 29. After the completion of the decoding by the error correction code B for all the data, the computation/control section 28 stops the receiving processing of the receiver section 25 through the interface 27, and the decoded data stored in the storing section 29 is outputted through the interface 27 to the data output circuit 30.

In addition, interleaving can be carried out for the error correction codes A and B by using the transmission side general-purpose computing section 20 and the receiving side general-purpose computing section 26. Moreover, the data sequence can be divided into a plurality of blocks, and a block having the error correction codes A and B as a pair can be transmitted by a plurality of times.

At the receiving side, the receiving side general-purpose computing section 26 can carry out repeated decoding. Specifically, determination is made by the computation/control section 28 as to the presence of an error in the correction result of the error correction code B stored in the storing section 29, and if the presence of an error is determined, then the decoding of the error correction code A is executed again, and determination processing is executed again, whereas if there is still an error, then the decoding of the error correction code B is executed.

In the described embodiment, the data input circuit 19, the transmission side general-purpose computing section 20, and the transmitter section 24 were separated. However, the transmission side general-purpose computing section 20 can incorporate the data input circuit 19, and the transmitter section 24. Similarly, the receiving side general-purpose computing section 26 can incorporate the receiver section 25 and the data output circuit 30.

### (Embodiment 13)

In the embodiment 3 or 7, the error correction code A was a block code composed of a plurality of code words, and the error correction code B was the convolutional code of a systematic type. However, these can be set as general concatenated codes. In this case, transmitter section takes a configuration similar to that of Fig. 1 or Fig. 9. But any transmission order can be set for the error correction codes A and B.

The operation at the receiving side is similar to that of the embodiment 3 or 7. However, it is not necessary to execute error detection for the decoded data of the error correction code A subjected to first decoding. In other words, it is not necessary to provide error determination circuit 6 like that shown in Fig. 3 or Fig. 12.

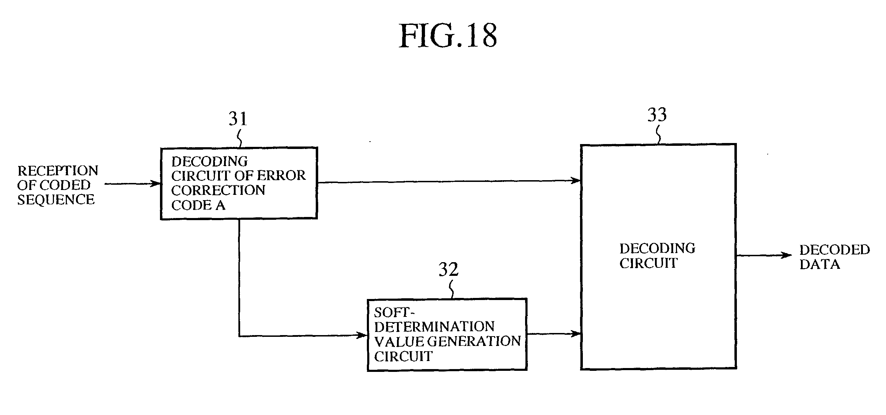

Now, the embodiment 13 using the number of corrected errors of the error correction code A in the error correction code B will be described. Fig. 18 shows an configuration example thereof, in which a reference numeral 31 denotes the decoding circuit of an error correction code A as an internal code; 32 a soft determination value generation circuit for generating a soft determination value based on the number of corrected errors outputted from the decoding circuit of the error correction code A; and 33 decoding circuit for executing soft determination decoding by an error correction code B as an external code.

Next, an operation will be described. A sequence to be received, composed of a plurality of code words, is subjected to decoding by the decoding circuit 31 of the internal code, and the number of corrected errors for each code word is obtained. In this case, if correction impossibility is determined, the correction impossibility can be set to be distinguished, for example t+1 with respect to the number of correction possible errors t. Then, the data obtained by the decoding circuit 3 of the internal code is entered to the decoding circuit 33 of the external code, and the number of corrected errors for each code word is also entered to the soft determination generation circuit 32.

At the soft determination value generation circuit 32, a soft determination value is generated according to the number of corrected errors. In this case, if the number of corrected errors is within a correction possible range, there should be no errors in the decoded data. However, correction may possibly be erroneous. Generally, however, as the number of corrected errors is smaller, a probability of erroneous correction is smaller. Thus, at the soft determination value generation circuit 32, a soft determination value is set corresponding to hard determination decoded data in accordance with the number of corrected errors including the correction possible range. Since an erroneous correction probability with respect to the number of corrected errors is exponential, a difference should preferably be generated for a soft determination value with respect to the number of corrected errors. For example, if a soft determination is t+1-m with respect to the number m of corrected errors equal to the number of errors, then conversion can be made only by a shifting operation on a connection.

Using the decoded data of the internal code, and the soft determination value entered by the soft determination generation circuit 32, the decoding circuit 33 of the external code executes soft determination decoding, e.g., Viterbi decoding, by simultaneously using the decoded data of the internal code, and the soft determination value generated based on the number of corrected errors corresponding to the decoded data, and then outputs the decoded data. In this case, it may be more advantageous if the adjacent decoded data sequence of the decoding circuit 33 of the external code have been subjected to interleaving such that the code words of the internal code can be different. Thus, soft determination decoding can be realized without obtaining any reliability information from the receiving side, and without controlling a reliability information addition mode for the decoded result of the internal code.

In the described embodiment, the internal code was a block code, and the external code was a systematic convolutional code. However, any code can be used for the internal code as long as it enables a decoding state to be obtained for the decoded data from a plurality of code words, and also any can be used for the external code as long as it facilitates soft determination decoding.

In addition, as in the case of the embodiment 3, decoded data may be only a part of the internal code with respect to the external code. In this case, soft determination is not obtained from the decoded data of the internal code, and soft determination information may be added for the coded sequence of the external code such that hard determination data can be valid, and reliability substantially equal to that of the correction impossible decoded data of the internal code can be set.

As apparent from the foregoing description, the present invention is advantageous in the following respects.

That is, according to the correction method and apparatus of the invention, for the data to be transmitted, an error correction coded sequence having small redundancy can be transmitted first, and an error correction coded sequence including data having a large correction capability can be subsequently transmitted. The data can be transmitted while protecting the data from an error with a short transmission bit length, and a strong error protection can be provided.

At the receiving side, the error correction coded sequence transmitted first including the data is subjected to decoding. If the presence of no errors in the decoding result is determined, the result is immediately outputted. If the presence of a remaining error is determined, the error correction coded sequence subsequently transmitted is subjected to decoding, and outputted. Accordingly, the error correction coded sequence transmitted first can be set as one including data, having small redundancy; and the error correction coded sequence transmitted subsequently as one having a large correction capability. Therefore, the data can be reproduced faster if the number of errors is small on the transmission path. Even if the number of errors is large, with transmission time substantially equal to that of the conventional case, a correction capability equal or exceeding that of the conventional case can be obtained by using the previous result of decoding.

According to the error correction method and apparatus of the invention, the coding circuit can be the one for protecting the data to be transmitted by the error correction code having a large correction capability; and the one with the error correction code having small redundancy for protecting the data to be transmitted and the check of the error correction code having a large correction capability. At the input switching circuit, the data and the error correction coded sequence having a large correction capability can be entered to the coding circuit of the error correction code having small redundancy. At the storing section, the error correction coded sequence having a large correction capability, to be transmitted later, can be stored. Thus, the data can be transmitted while the data is protected from an error with a short transmission bit length, and a strong error protection can be provided.

At the receiving side, decoding, storing and output circuit are respectively provided as follows: first decoding circuit for decoding an error correction code having small redundancy; storing section for storing the data thus decoded in the decoding circuit; second decoding circuit for outputting decoded data from the decoded data stored in the storing section and an error correction coded sequence having a large correction capability, outputted from the decoding circuit for decoding the error correction code having small redundancy; and output circuit for immediately outputting the result thereof if the determination circuit determines the presence of no errors in the decoded data of the first decoding circuit. In this case, the data can be reproduced faster if the number of errors is small on the transmission path. Even if the number of errors is large, a very strong correction capability can be obtained by using the previously decoding result.

The error correction method and apparatus of the invention comprise: the coding circuit for protecting data to be transmitted by one error correction code; the transmission procedure circuit for first transmitting only a part of the coded sequence including the data, and subsequently transmitting the remaining error correction coded sequence; and the storing section for storing the error correction coded sequence for subsequent transmission. Thus, the data can be transmitted while the data is protected from an error with a short transmission bit length by one coding circuit, and a strong error protection can be provided.

At the receiving side, the apparatus comprises: the decoding circuit for executing decoding by a part of the error correction coded sequence including the data transmitted first; the storing section for storing the sequence to be received thereof; another decoding circuit for synthesizing the remaining error correction coded sequence subsequently sent-in, with a part of the error correction coded sequence including the data first transmitted, and then decoding it; the determination circuit for decoding the error correction coded sequence including the data first transmitted, and determining whether or not there are any errors in the decoded result; and the output circuit for immediately outputting the result thereof if the presence of no errors is determined by the determination circuit. Thus, by one decoding circuit, the data can be reproduced faster if the number of errors is small on the transmission path. Even if the number of errors is small, a strong correction capability can be provided by using the previous decoding result.

According to the error correction method and apparatus of the invention, the coding circuit of the concatenated code includes: the coding circuit of the inner code generated by the coded sequence composed of a plurality of code words; and the coding circuit of the external code subjected to, e.g., soft determination for generating a convolutional code. Thus, a strong error protection can be provided.

Furthermore, at the receiving side, the decoding circuit of the concatenated code includes: the decoding circuit of the internal code for decoding the coded sequence composed of a plurality of code words, and outputting the number of errors; and the decoding circuit of the external code for executing decoding based on the rule of the convolutional code by using the decoded data of the internal code, and the number of errors.
Thus, the necessities of obtaining a soft determination value for the received data, and controlling the reliability information addition mode before the decoding of the external code can be eliminated. Soft determination decoding can be carried out to obtain a strong correction capability.

## Claims

1. An error correction method for protecting data by correcting a plurality of errors for data transmission, comprising the steps of:
first transmitting a coded sequence composed of a data and error correction codes added thereto, having small redundancy; and thereafter
transmitting either only data, the coded sequence of the data with an error correction code, only a check portion of error correction code for protecting any other error correction coded sequences, having a large correction capability for protecting the same data, or the entire coded sequence including the check portion, only a check portion of another error correction code having a large correction capability for protecting the coded sequence, or the entire coded sequence including the check portion.

2. The error correction method for protecting data by correcting a plurality of errors according to claim 1, wherein it is based on one error correction code parameter in data transmission according to claim 1, said method comprising the steps of: transmitting first a part of a coded sequence generated for data at a predetermined interval; and thereafter transmitting a remaining part, not having been transmitted first, of the coded sequence.

3. The error correction method according to claim 1, wherein the data transmitted first contains information regarding a data length, and the data is protected based on a third error correction code.

4. The error correction method according to claim 1, wherein a data sequence to be protected contains an error detection code.

5. The error correction method according to claim 3, wherein the data length is protected by the third error correction code or an error detection code, and is transmitted a plurality of times between the transmissions of coded sequences composed of the data and an error correction code therefor.

6. An error correction method for protecting data by correcting a plurality of errors in data transmission, said method comprising the steps of:
first executing decoding of the error correction coded sequence upon receiving data and an error correction code for protecting the data;
outputting a data sequence obtained by the decoding operation without receiving a subsequent sequence to be received if no errors are determined to be present in the data after the decoding, or alternatively receiving the subsequent coded sequence if errors are determined to be remaining; and
executing decoding of the subsequent error correction coded sequence by using the subsequently received coded sequence and the decoded result of the previously received coded sequence, or the previously received data sequence, and outputting a result of the decoding.

7. The error correction method according to claim 6, wherein the subsequent error correction coded sequence constitutes an error correction coded sequence for protecting another error correction coded sequence for protecting the data, and if errors are determined to be remaining, decoding is executed by using the result of decoding of the previously received error correction coded sequence, and the result of decoding of the error correction coded sequence for another error correction coded sequence, and data obtained by the decoding of said another error correction codes sequence is outputted.

8. The error correction method for protecting data according to claim 6, wherein it is based on one error correction parameter, and performed by correcting a plurality of errors, wherein the decoding is first executed for a part of the previously received error correction coded sequence, and the result of the decoding is outputted if no errors are determined to be present in the data after the decoding, whereas the decoding is executed after receiving the subsequent sequence to be received and rebuilding error correction coded sequence if errors are determined to be remaining, and then the result of the decoding is outputted.

9. The error correction method according to claim 6, wherein after the decoding executed by said another error correction coded sequence subsequently received, decoding is executed again of the previously received error correction coded sequence by using the decoded result of said another error correction coded sequence, and the previously received error correction coded sequence.

10. The error correction method according to claim 6, wherein the error correction coded sequence to be decoded first is composed of a plurality of code word sequence, and if an error is determined to be present in the decoding of the error correction coded sequence to be decoded, another error correction coded sequence to be subsequently decoded is decoded by using data regarding the previously decoded error correction coded sequence, and soft determination decoding is executed by using the number of corrected ones of the plurality of previously decoded error correction coded sequence or the number of received data errors, corresponding to decoding data obtained in the decoding of the previously decoded error correction coded sequence.

11. The error correction method according to claim 6, wherein if a data sequence to be protected contains an error detection code, after decoding by an error correction coded sequence containing the error detection code, determination is made as to presence of remaining errors based on the error detection code.

12. The error correction method according to claim 6, wherein data to be sent first contains information regarding a data length and, based on the result of decoding thereof, a code length or the number of code words of an error correction code, and a code length or the number of code words of another error correction code are estimated.

13. The error correction method according to claim 12, wherein the data length is protected by a third error correction code or the error detection code, the data length is received by a plurality of times between the receptions of data sequences composed of the data itself and an error correction code thereof and, if reception of a correct data length is determined by the third error correction code or the error detection code, based on the result of decoding thereof, a code length or the number of code words of an error correction code, and a code length or the number of code words of another error correction code are estimated.
